# EUROPEAN PATENT APPLICATION

(11) **EP 4 654 781 A1**
(43) Date of publication of application: **26.11.2025**
(21) Application number: 25176592.1
(22) Date of filing: 15.05.2025
(51) Int. Cl.: H10D 30/65, H10D 30/60, H10D 62/10, H10D 62/13, H10D 62/17

(54) **LATERAL-CONDUCTION MOSFET DEVICE HAVING A REDUCED AREA OCCUPANCY**

(30) Priority: 22.05.2024 IT 202400011647
(71) Applicant: STMicroelectronics International N.V., 1228 Plan-les-Ouates, Geneva (CH)
(72) Inventor: BASSO, Michele, 20092 CINISELLO BALSAMO (MI) (IT)
(74) Representative: Studio Torta S.p.A.

(57) **Abstract**

A lateral-conduction MOSFET device has a semiconductor body (53); a plurality of source regions (55A, 55B) of a first conductivity type (N), which extend into the body each along a first direction (Y) at a distance from each other along a second direction (X) transversal to the first direction, wherein each source region has a first portion (61A, 62A) and a second portion (60A, 63B) alongside the first portion along the first direction; and a plurality of body contact regions (68A, 69A), distinct from each other, one for each source region, of a second conductivity type (P) different from the first, which extend into the body alongside and in contact with the respective first portion parallel to the second direction (X). The first portion of each source region and the respective body contact region together have a width (W₁) along the second direction. The second portion of each source region has a respective second width (W₂) along the second direction. The first width is greater than the second width.

## Description

### Technical Field

The present invention relates to a lateral-conduction MOSFET device having a reduced area occupancy.

### Background

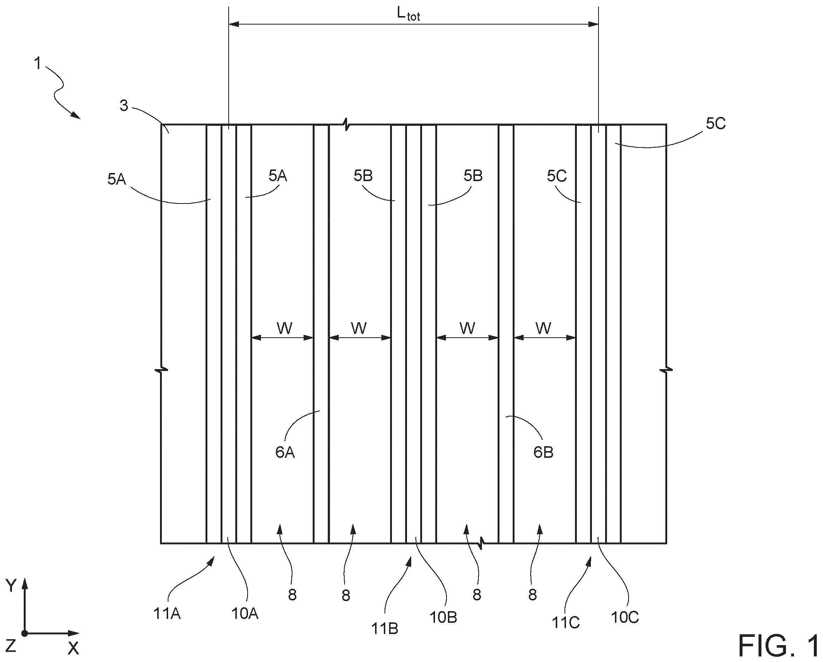

Figure 1 shows a simplified top-plan view of a known MOSFET device 1 in a Cartesian reference system having axes X, Y, Z.

The MOSFET device 1 is of the lateral-conduction type and is formed in a body 3 of semiconductor material.

The MOSFET device 1 comprises a plurality of source regions, in particular three source regions 5A, 5B, 5C extending into the semiconductor body parallel to the Y axis and at a distance from each other along the X axis.

Two drain regions 6A, 6B extend parallel to the Y axis and are arranged, along the X axis, between the source regions 5A, 5B and, respectively, between the source regions 5B, 5C.

The source regions 5A-5C and the drain regions 6A, 6B have a same conductivity type, for example N-type.

Regions 8 (not shown in detail), which comprise drift regions and gate regions for controlling, in use, the conductive channel of the MOSFET device 1, extend between the source regions 5A-5C and the respective drain regions 6A, 6B, depending on the specific typology of MOSFET device 1.

The MOSFET device 1 further comprises a plurality of body contact regions 10A, 10B, 10C, one for each source region 5A, 5B, 5C. The body contact regions 10A-10C have a conductivity type different from that of the source regions, for example they are of P-type, and are used, in use, for biasing the body regions (here not shown).

The body contact regions 10A-10C are each accommodated within a respective source region 5A-5C, in contact with the respective source region 5A-5C parallel to the X axis.

In practice, the source regions 5A-5C and the body contact regions 10A-10C form fingers 11A-11C having main extension parallel to the Y axis.

The fingers 11A-11C have, along the X axis, a constant width throughout the length of the fingers 11A-11C along the Y axis.

In practice, the fingers 11A-11C and the drain regions 6A, 6B have a rectilinear extension parallel to the Y axis.

As a result, in the MOSFET device 1, the drain regions 6A, 6B extend, along the X axis, all at a same distance W from the adjacent source regions 5A-5C.

The MOSFET device 1 has an area occupancy in the semiconductor body 3 that depends on the overall width of the fingers 11A-11C, indicated in Figure 1 by Lₜₒₜ and measured along the X axis between the first source region 5A and the last source region 5C, in particular measured in Figure 1 between middle points of the fingers 11A and 11C.

As is known, one of the main figures of merit in a lateral-conduction MOSFET device is the product between the on-state resistance R_{ds, on} and the area through which, in use, the current flows between the source region and the drain region.

The Applicant has observed that, in the known MOSFET device 1, this figure of merit is not sufficiently low, in particular in low-voltage applications, for example lower than 30 V.

US 2001/015458 A1, US 2019/115468 A1 and US 11 152 503 B1 disclose further examples of MOSFET devices.

The aim of the present invention is to overcome the drawbacks of the prior art.

### Summary

According to the present invention, a lateral-conduction MOSFET device is therefore provided, as defined in the attached claims.

### Brief Description of the Drawings

For a better understanding of the present invention, embodiments thereof are now described, purely by way of nonlimiting example, with reference to the attached drawings, wherein:
- Figure 1 shows a schematic top-plan view of a known lateral-conduction MOSFET device;
- Figure 2 shows a schematic top-plan view of a lateral-conduction MOSFET device, according to an embodiment of the invention;
- Figure 3 shows a detailed top-plan view of a portion of the MOSFET device of Figure 2;
- Figure 4A shows a cross-section of the MOSFET device of Figure 2, along a section line IV-A - IV-A of Figure 2;
- Figure 4B shows a cross-section of the MOSFET device of Figure 2, along a section line IV-B - IV-B of Figure 2; and
- Figure 5 shows a schematic top-plan view of a lateral-conduction MOSFET device, according to a different embodiment of the invention.

### Description of Embodiments

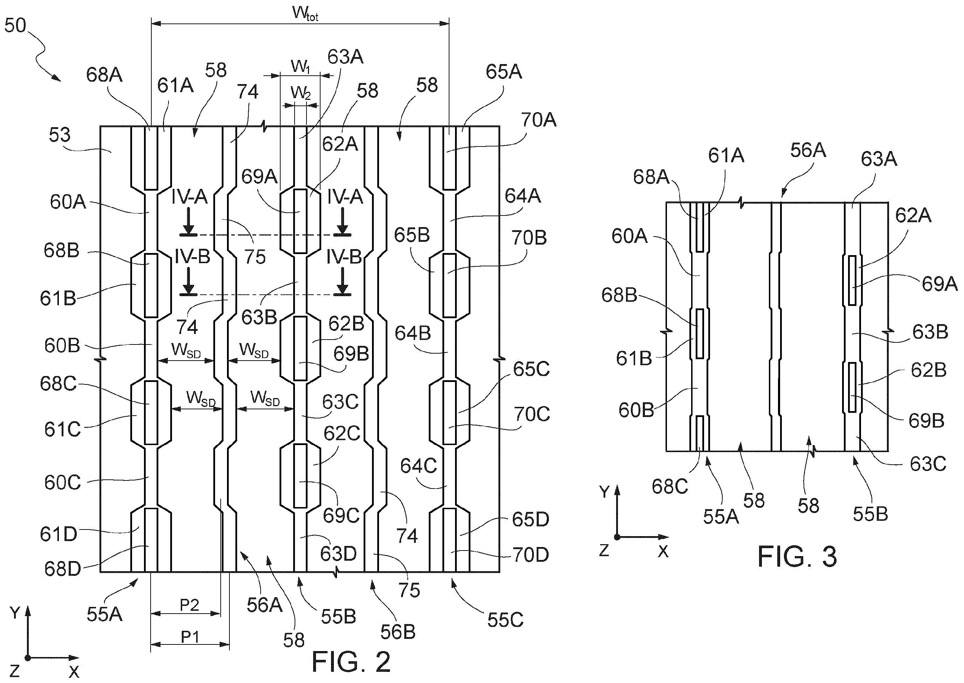

Figures 2, 3, 4A and 4B show a lateral-conduction MOSFET device 50 (hereinafter simply referred to as MOSFET device 50), in a Cartesian reference system having axes X, Y, Z.

In the embodiment shown, the MOSFET device 50 is a double-diffused MOSFET (DMOS) device; however, the MOSFET device 50 may be of a different type, for example CMOS, NMOS, PMOS, or other typologies.

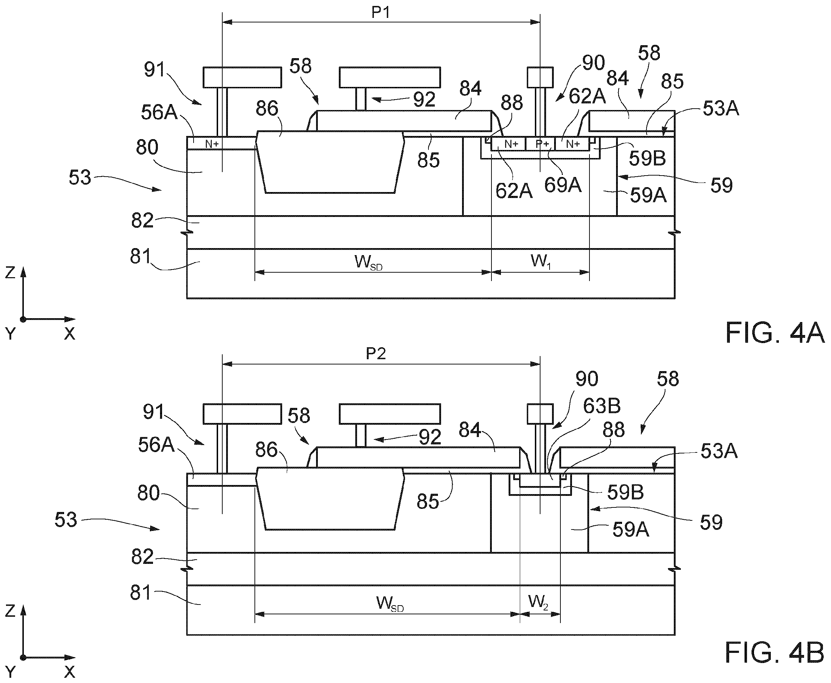

The MOSFET device 50 is formed in a semiconductor body 53, for example of silicon, silicon carbide or other semiconductor materials, having a front side 53A (Figures 4A, 4B).

The MOSFET device 50 comprises a plurality of source regions, of which three source regions 55A, 55B, 55C are shown in Figure 1, extending into the semiconductor body 53 each along a respective direction parallel to the Y axis, at a distance from each other along the X axis, for example at a fixed or determined distance from each other.

The MOSFET device 50 further comprises a plurality of drain regions, of which two drain regions 56A, 56B are shown in Figure 1, each arranged in the semiconductor body 53 between two adjacent source regions.

In practice, the source regions 55A-55C and the drain regions 56A, 56B are linear regions elongated parallel to the Y axis, in particular having main extension parallel to the Y axis.

In detail, the drain region 56A extends, along the X axis, into the semiconductor body 53 between the source regions 55A and 55B, and the drain region 56B extends, along the X axes, into the semiconductor body 53 between the source regions 55B and 55C.

The source regions 55A-55C and the drain regions 56A, 56B are for example of N-type, in particular of N+ type.

Drift regions 58 extend between each source region 55A-55C and the respective adjacent drain region 56A, 56B. The drift regions 58 may comprise specific functional regions depending on the specific typology of MOSFET device, as discussed in detail below.

In detail, the source region 55A comprises a plurality of narrow portions 60A, 60B, 60C and a plurality of wide portions 61A, 61B, 61C, 61D which alternate with each other parallel to the Y axis (i.e., in the Y-axis direction). The source region 55B comprises a plurality of narrow portions 62A, 62B, 62C, 62D and a plurality of wide portions 63A, 63B, 63C that alternate with each other parallel to the Y axis. The source region 55C comprises a plurality of narrow portions 64A, 64B, 64C and a plurality of wide portions 65A, 65B, 65C, 65D which alternate with each other parallel to the Y axis.

Each narrow portion of a source region extends alongside, parallel to the Y axis, the respective adjacent wide portion.

In detail, for each source region 55A-55C, the narrow portions and the wide portions are contiguous with each other, in particular throughout the length of the respective source region along the Y-axis direction.

In Figure 2, for simplicity, the transition between the narrow portions and the wide portions of each source region 55A-55C are shown only schematically. The specific shape of the transition between narrow portions and wide portions may depend on the manufacturing processes used and on design needs. Figure 3 shows an enlarged detail of the connection between narrow portions 60A, 60B, 63A, 63B and the respective wide portions 61A, 61B, 61C, 62A, 62B.

The source regions 55A-55C each extend within a respective body region of P-type.

In Figures 4A and 4B, of the body regions, only the body region 59 of the source region 55B is shown. In this embodiment, the body region 59 comprises a first portion 59A and a second portion 59B accommodated in the first portion 59A.

The MOSFET device 50 further comprises a plurality of body contact regions of P-type (in particular P+ type), distinct from each other, arranged within the source regions 55A-55C.

The body contact regions extend in contact with the respective body regions and have a higher doping level than the body regions.

In detail, the MOSFET device 50 comprises four body contact regions 68A, 68B, 68C, 68D accommodated in the source region 55A, three body contact regions 69A, 69B, 69C accommodated in the source region 55B, and four body contact regions 70A, 70B, 70C, 70D accommodated in the source region 55C.

The body contact regions 68A-68D, 69A-69C and 70A-70D are arranged in contact with the wide portions of the respective source portions 55A-55C, parallel to the X axis.

In detail, the body contact regions 68A-68D are each accommodated in a respective wide portion 61A-61D of the source region 55A.

The body contact regions 69A-69C are each accommodated in a respective wide portion 62A-62C of the source region 55B.

The body contact regions 70A-70D are each accommodated in a respective wide portion 65A-65D of the source region 55C.

The body contact regions 68A-68D, 69A-69C, 70A-70D are in electrical contact with the respective source regions 55A-55C, in particular each with the respective wide portion being in contact therewith.

Referring by way of example to the source region 55B, the narrow portions 63A-63D each have a width W₂ measured along the X axis.

The wide portions 62A-62C each form, together with the respective body contact region 69A-69C, a region having a width W₁, measured along the X axis, greater than the width W₂. In other words, the wide portions 62A-62C each occupy the width W₁ in the semiconductor body 53.

What has been discussed for the width of the narrow and wide portions of the source region 55A also applies, *mutatis mutandis,* to the narrow and wide portions of the source regions 55A and 55C.

Furthermore, in this embodiment, the body contact regions of each source region are vertically staggered, i.e. along the Y-axis direction, with respect to the body contact regions of the adjacent source region.

In detail, the body contact regions 68A-68D of the source region 55A are vertically staggered with respect to the body contact regions 69A-69C of the source region 55B.

The body contact regions 69A-69D of the source region 55B are also vertically staggered with respect to the body contact regions 70A-70D of the source region 55C.

In particular, the body contact regions 68A-68D do not face, parallel to the X axis, the body contact regions 69A-69C of the adjacent source region 55B. Likewise, in this embodiment, the body contact regions 69A-69C do not face, parallel to the X axis, the body contact regions 70A-70D of the adjacent source region 55C.

However, in the MOSFET device 50, the body contact regions 68A-68D of the source region 55A face, in particular are aligned, parallel to the X axis, with respect to the body contact regions 70A-70D of the source region 55C.

In the MOSFET device 50, the body contact regions (68A-68D and 69A-69C) that are accommodated in pairs of adjacent source regions (55A, 55B) along the X axis are vertically staggered with each other.

In other words, in the MOSFET device 50, the body contact regions that are vertically staggered with each other are distributed on pairs of adjacent source regions along the X axis.

Consequently, the wide portions of a source region (for example the wide portion 62A of the source region 55A) are vertically staggered with respect to the wide portions of the adjacent source regions (for example the wide portions 61A, 61B of the source region 55A and the wide portions 65A, 65B of the source region 55C).

In the MOSFET device 50, the drain regions 56A, 56B extend parallel to the Y axis so as to keep a distance W_{SD} constant, along the X axis, with the respective adjacent source regions 55A-55C.

In this embodiment, the drain regions 56A, 56B have a non-rectilinear trend parallel to the Y axis.

In detail, the drain regions 56A, 56B comprise a plurality of portions 74, 75 which alternate with each other parallel to the Y axis.

In particular, the portions 74, 75 are contiguous with each other parallel to the Y axis and are horizontally (along the X axis) staggered with each other.

In Figure 2, for simplicity, the trend of the drain regions 56A, 56B along the Y-axis direction is shown only schematically; the specific trend may in fact depend on the manufacturing processes used and on design needs. Figure 3 shows a detailed example of the trend of the drain region 56A along the Y-axis direction.

In practice, in the MOSFET device 50, each source-drain pair may have two pitch values P1, P2.

In Figures 2 and 4A-4B, the pitch values P1, P2 are defined as the distance, along the X axis, between an intermediate portion of a source region and an intermediate portion of the adjacent drain region.

In detail, the pitch value P1 is defined as the distance, along the X axis, between half of a source region (for example the source region 55A) and half of the adjacent drain region (for example the drain region 56A), at the wide portions of the respective source region (for example the portions 61A-61D of the source region 55A).

The pitch value P2 is defined as the distance, along the X axis, between half of a source region (for example the source region 55A) and half of the adjacent drain region (for example the drain region 56A), at the narrow portions of the respective source region (for example the portions 60A-60C of the source region 55A).

In practice, pitch P1 is greater than pitch P2.

A width Wₜₒₜ of the MOSFET device 50 may be defined as the overall width of the source regions 55A-55C in the semiconductor body 53.

In detail, as shown in Figure 2, by way of example, the width Wₜₒₜ is measured, along the X axis, between half of the source region 55A and half of the source region 55C.

Referring to the sections of Figures 4A and 4B, the semiconductor body 53 comprises a surface region 80 at the front side 53A, of N-type, in particular having a lower doping level than that of the source regions 55A-55C and the drain regions 56A-56B.

The semiconductor body 53 may also comprise a substrate 81 and/or a doped region 82 arranged along the Z axis between the surface region 80 and the substrate 81. The doped region 82 may be of N-type and have a high doping level, in particular higher than the surface region 80. The doped region 82 may be useful, in use, to improve the performances of the MOSFET device 50 (for example for decreasing the on-state resistance and at the same time keeping a high breakdown voltage) and to insulate the MOSFET device 50 from further electronic devices formed in the semiconductor body 53.

The drift regions 58 each comprise a gate insulated region for controlling, in-use, the turn-on and turn-off of the MOSFET device 50, having a conductive region 84, for example of polysilicon or metallic material, and a gate insulation region 85, for example of a dielectric or insulating material, extending between the semiconductor body 53 and the conductive region 84.

The drift regions 58 each also comprise an insulating region 86, for example of oxide, which extends into the semiconductor body 53 starting from the front side 53A.

In detail, the insulating region 86 may be a surface insulation trench that extends in part, along the Z axis, through the thickness of the surface region 80 of the semiconductor body 53.

The MOSFET device 50 may further comprise, for each source region 55A-55C, doped portions 88 (optional) of the same conductivity type as the source regions 55A-55C (N) and a lower doping level than the source regions 55A-55C.

The doped portions 88 each extend, parallel to the X axis, alongside the respective source region 55A-55C, within the body region 59 and in particular of the respective portion 59B.

The distance W_{SD} between each source region 55A-55C and the respective adjacent drain region 56A, 56B may be kept constant, moving parallel to the Y axis, by adjusting, during the design step, the width of one or more of the portions that extend parallel to the X axis between each source region 55A-55C and the adjacent drain region 56A, 56B.

For example, referring by way of example to the sections of Figures 4A and 4B, the portions 59A, 59B of the body region 59 have, along the X axis, different widths at the narrow portions of the source regions 55A-55C and at the wide portions of the source regions 55A-55C.

In detail, the body region 59 has, at the narrow portion 63B, a smaller width with respect to the width at the wide portion 62A.

Still referring to Figures 4A and 4B, the MOSFET device 50 may comprise conductive regions 90, 91, 92, for example of metallic material, extending in contact with, respectively, the source regions 55A-55C and the body contact regions (of which only portion 69A is shown), the drain regions 56A, 56B, and the conductive regions 84 of the gate insulated regions, for the respective biasing, in use.

The conductive regions 90, 91, 92 may comprise vias, extending along the Z axis in contact with the respective regions to be biased, and interconnection regions extending over the semiconductor body 53.

The presence of body contact regions distinct from each other and the corresponding variability of the width (W₁, W₂) of the source regions 55A-55C cause, overall, the MOSFET device 50 to be capable of having a low width in the semiconductor body 53 and, therefore, be capable of having a low area occupancy in the semiconductor body 53.

In fact, with the same design parameters and number of source regions, the width Wₜₒₜ of the MOSFET device 50 may be smaller than the width Lₜₒₜ of the MOSFET device 1 of Figure 1, at the same time without altering the on-state resistance R_{ds, on} .

In particular, the obtainable percentage reduction of area is greater as the average pitch of the MOSFET 50 device decreases; for example, the area reduction may be greater in MOSFET devices for low-voltage applications, such as at voltages lower than 50 V, in particular lower than 30 V.

In addition, the fact that the body contact regions of adjacent source regions are vertically staggered with each other, at least in part, allows the area of the MOSFET device 50 to be reduced and, at the same time, the drain-source distance W_{SD} to be kept constant.

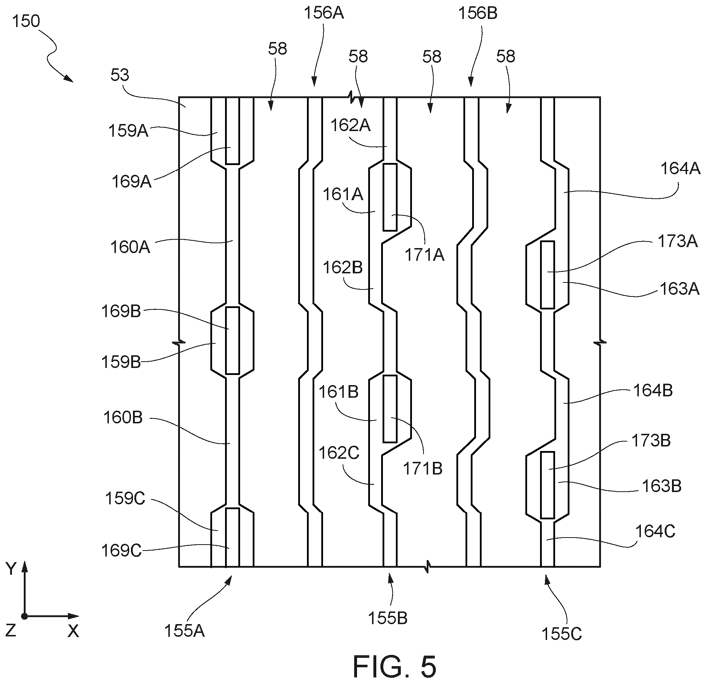

Figure 5 shows a lateral-conduction MOSFET device, indicated by 150, according to a different embodiment. The MOSFET device 150 may be of the same type (DMOS) as the MOSFET device 50 or of a different type.

The MOSFET device 150 has a general structure similar to that of the MOSFET device 50; as a result, elements in common are indicated by the same reference numerals and are not further described in detail.

The MOSFET device 150 is formed in the semiconductor body 53 and comprises a plurality of source regions, in particular three source regions 155A, 155B, 155C, having an elongated shape parallel to the Y axis and arranged at a distance from each other parallel to the X axis; and drain regions 156A, 156B each arranged between two adjacent source regions.

Drift regions 58 extend along the X axis each between a source region 155A-155C and the adjacent drain region 156A, 156B.

As discussed for the MOSFET device 50, the source regions 155A-155C also comprise respective narrow portions and respective wide portions that alternate with each other parallel to the Y axis.

In particular, the source region 155A comprises three wide portions 159A, 159B, 159C and two narrow portions 160A, 160B; the source region 155B comprises two wide portions 161A, 161B and three narrow portions 162A, 162B, 162C; and the source region 155C comprises two wide portions 163A, 163B and three narrow portions 164A, 164B, 164C.

The MOSFET device 150 comprises body contact regions, each at the wide portion of a respective source region.

In detail, the MOSFET device 150 comprises body contact regions 169A, 169B, 169C each in contact with and alongside, parallel to the X axis, the wide portions 159A, 159B and, respectively, 159C of the source region 155A; body contact regions 171A, 171B each in contact with and alongside, parallel to the X axis, the wide portions 161A and, respectively, 161B of the source region 155B; and body contact regions 173A, 173B each in contact with and alongside, parallel to the X axis, the wide portions 163A and, respectively, 163B of the source region 155C.

The body contact regions 169A-169C, 171A-171B, 173A-173B are in electrical contact with the respective source regions 155A-155C, in particular each with the respective wide portion in contact therewith.

In practice, the body contact regions may each be accommodated within a respective wide portion, in contact with a body region (here not shown), for biasing the body region.

In the MOSFET device 150, the body contact regions 169A, 171A and 173A are vertically staggered with each other, i.e. staggered along the Y axis.

In particular, the body contact regions 169A, 171A and 173A do not face each other parallel to the X axis.

In the MOSFET device 150, the body contact regions 169B, 171B and 173B are also vertically staggered with each other, i.e. staggered along the Y axis.

In particular, all the body contact regions of the source regions 155A-155C are staggered to each other, in particular completely staggered to each other (i.e. without mutual overlaps).

In other words, in the MOSFET device 150, the body contact regions that are vertically staggered to each other are distributed on three adjacent source regions (155A, 155B, 155C) instead of on two adjacent source regions (as discussed for the MOSFET device 50).

This allows to further reduce the overall width along the X axis of the MOSFET device 150 with respect to the MOSFET device 50 of Figure 2.

In the MOSFET device 150, the drain regions 156A, 156B and the source regions 155A-155C extend parallel to the Y axis so as to keep the respective distance W_{sd} constant, similarly to what has been discussed for the MOSFET device 50.

In particular, both the drain regions 156A, 156B and the source regions 155A-155C have a non-rectilinear trend in the direction of the Y axis and comprise portions that are at least in part horizontally (parallel to the X axis) staggered to each other.

As discussed with reference to Figures 2 and 3, the trend of the source 155A-155C and drain 156A, 156B regions of the MOSFET device 150 is also shown only schematically in Figure 5; in fact, the specific transition between portions that are mutually staggered along the X axis may depend on the manufacturing processes used and on specific design needs.

Finally, it is clear that other modifications and variations may be made to the MOSFET devices described and illustrated herein without thereby departing from the scope of the present invention, as defined in the attached claims.

For example, the body contact regions that are vertically staggered to each other may be distributed on a number of adjacent source regions greater than three. Increasing the number of source regions may allow the overall width of the MOSFET device to be further reduced and therefore the respective area occupancy in the semiconductor body to be decreased.

For example, one or more of the source regions may comprise a single narrow portion and a single wide portion; consequently, the MOSFET device may comprise a single body contact region for each source region. For example, in such a case, the body contact regions may each extend for about half the length along the Y axis of the respective source region and vertically staggered with respect to the body contact region of an adjacent source region.

For example, the MOSFET device may comprise a different number of source, drain, and drift regions than shown, depending on specific design needs.

For example, source, drain and drift regions may have non-linear extension parallel to the Y axis, but instead circular or substantially circular extension, one within the other.

Referring to the sections of Figures 4A and 4B, the MOSFET device may comprise, in the semiconductor body 53, portions different from those shown and described. For example, further doped regions may be arranged in the semiconductor body 53 below the drain regions 56A, 56B.

For example, the arrangement of the body contact regions may be different from that shown and described, for example they may have a regular arrangement different from that shown or a non-regular arrangement, depending on the specific application.

The gate insulated regions may be of a different type from what has been shown, for example of the trench-type, i.e. extending in part also within the semiconductor body.

For example, the substrate 81 may be of insulating material.

For example, the conductivity type (P, N) may be reversed with respect to what has been discussed above, depending on the specific type of MOSFET device (N-channel or P-channel MOSFET device) that it is intended to provide.

## Claims

1. A lateral-conduction MOSFET device comprising:
a semiconductor body (53);
a plurality of source regions (55A, 55B; 155A, 155B, 155C) having a first conductivity type (N), extending into the semiconductor body each along a first direction (Y) and at a distance from each other along a second direction (X) transversal to the first direction, each source region comprising a respective first portion (61A, 62A; 159A, 161A, 163A) and a respective second portion (60A, 63B; 160A, 162B, 164B) alongside the first portion along the first direction; and
a first plurality of body contact regions (68A, 69A; 169A, 171A, 173A), distinct from each other, of which one for each source region (55A, 55B; 155A-155C), having a second conductivity type (P) different from the first conductivity type, each extending into the semiconductor body (53) alongside and in contact with the first portion of the respective source region parallel to the second direction (X),
wherein the first portion (61A, 62A; 159A, 161A, 163A) of each source region and the respective body contact region (68A, 69A; 169A, 171A, 173A) together have a respective first width (W₁) along the second direction (X), wherein the second portion (60A, 63B; 160A, 162B, 164B) of each source region has a respective second width (W₂) along the second direction (X), the first width being greater than second width.

2. The MOSFET device according to the preceding claim, wherein the body contact region (68A; 171A) of a source region (55A; 155B) is staggered at least in part, parallel to the first direction (Y), with respect to the body contact region (69A; 169A, 173A) of the adjacent source regions (55B; 155A, 155C).

3. The MOSFET device according to claim 1 or 2, wherein the body contact regions (169A, 171A, 173A) of the first plurality of body contact regions are all staggered to each other, at least in part, parallel to the first direction (Y).

4. The MOSFET device according to any of the preceding claims, wherein the source regions (55A, 55B; 155A-155C) each further comprise a respective third portion (61B, 62B; 159B, 161B, 163B) contiguous to the respective second portion along the respective first direction (Y), the second portion extending between the first and the third portions along the respective first direction.

5. The MOSFET device according to claim 4, comprising a second plurality of body contact regions (68B, 69B; 169B, 171B, 173B), distinct from each other, of which at least one for each source region, having the second conductivity type (P), extending into the semiconductor body alongside and in contact with the third portion (61B, 62B; 159B, 161B, 163B) of the respective source region parallel to the second direction (X).

6. The MOSFET device according to claim 5, wherein the third portion of each source region and the respective body contact region of the second plurality of body contact regions together have a third width (W₁) along the second direction (X) which is greater than the second width (W₂).

7. The MOSFET device according to the preceding claim, wherein the body contact regions of the second plurality of body contact regions (68B, 69B; 169B, 171B, 173B) are at least in part staggered to each other parallel to the first direction (Y).

8. The MOSFET device according to any of claims 4-7, wherein the body contact regions of the first plurality of body contact regions (69A; 171A, 173A) are at least in part staggered with respect to the body contact regions of the second plurality of body contact regions (68B; 169B, 171B, 173B), parallel to the first direction (Y).

9. The MOSFET device according to any of the preceding claims, further comprising at least one drain region (56A, 56B; 156A, 156B) having the first conductivity type (N), each drain region being arranged, along the second direction (X), between two adjacent source regions, and extending into the semiconductor body so as to have a constant distance (W_{sd}), along the second direction (X), from the respective adjacent source regions.

10. The MOSFET device according to the preceding claim, wherein at least one of the drain region and the source regions has a non-rectilinear trend parallel to the first direction (Y).

11. The MOSFET device according to any of the preceding claims, further comprising a body region (59) for each source region (55A, 55B; 155A, 155B, 155C), having the second conductivity type (P) and extending into the semiconductor body.

12. The MOSFET device according to claim 11, wherein each source region is arranged in the respective body region, the body contact regions extending in the semiconductor body in contact with the body region of the respective source region.

13. The MOSFET device according to any of the preceding claims, for low-voltage applications, for example lower than 50 V.

14. The MOSFET device according to any of the preceding claims, wherein the body contact region (68A; 171A) of a source region (55A; 155B) is totally staggered, parallel to the first direction (Y), with respect to the body contact region (69A; 169A, 173A) of the adjacent source regions (55B; 155A, 155C).

15. The MOSFET device according to any of the preceding claims, wherein the body contact regions (169A, 171A, 173A) of the first plurality of body contact regions are all totally staggered to each other parallel to the first direction (Y).
